# EUROPEAN PATENT APPLICATION

(11) **EP 4 745 668 A1**
(43) Date of publication of application: **20.05.2026**
(21) Application number: 24839568.3
(22) Date of filing: 01.07.2024
(51) Int. Cl.: G03F 7/038, C08G 59/24, C08G 59/68, G03F 7/004, G03F 7/20

(54) **PHOTOSENSITIVE RESIN COMPOSITION, PATTERN FORMATION METHOD, AND METHOD FOR PRODUCING LAMINATE**

(30) Priority: 13.07.2023 JP 2023115393
(71) Applicant: TOKYO OHKA KOGYO CO., LTD., Kawasaki-shi, Kanagawa 211 0012 (JP)
(72) Inventor: SAITO, Yohei, Kawasaki-shi, Kanagawa 211-0012 (JP); YAMAGATA, Kenichi, Kawasaki-shi, Kanagawa 211-0012 (JP)
(74) Representative: Plasseraud IP
(86) International application number: PCT/JP2024/023755
(87) International publication number: WO 2025/013676

(57) **Abstract**

A photosensitive resin composition includes a hydrogenated bisphenol A type epoxy resin (A1) having an epoxy equivalent of 600 or greater, and a photoacid generator (B1) represented by General Formula (b-1). In the formula, R^{b1} to R^{b3} each independently represent an aryl group, a heteroaryl group, an alkyl group, or an alkenyl group, which may have a substituent. Here, R^{b1} to R^{b3} have no fused ring. R^{b4} to R^{b7} each independently represent an aryl group which may have a substituent, or a fluorine atom.

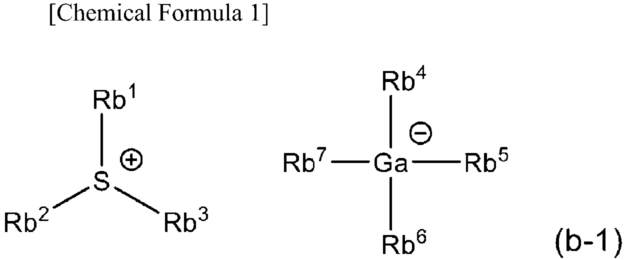

## Description

### TECHNICAL FIELD

The present invention relates to a photosensitive resin composition, a pattern formation method, and a method for producing a laminate.

Priority is claimed on Japanese Patent Application No. 2023-115393, filed July 13, 2023, the content of which is incorporated herein by reference.

### BACKGROUND ART

A microchannel device is obtained by, for example, forming a mold using a photolithography technology, pouring dimethylpolysiloxane (PDMS) into the mold to form a predetermined pattern, peeling off the PDMS on which the predetermined pattern is formed from the mold, and bonding the PDMS to a glass substrate or the like (see, for example, Patent Documents 1 and 2).

However, since PDMS has low heat resistance, there is a concern that elution may occur in the bonding step. In addition, the production process using PDMS has a problem of a large number of man-hours. Therefore, the application of a photosensitive adhesive as a substitute for PDMS is required for the production of a microchannel device or a BioMEMS device such as u-TAS, and various materials have been proposed (for example, see Patent Documents 3 and 4).

### Citation List

### Patent Documents

Patent Document 1: Japanese Unexamined Patent Application, First Publication No. 2001-157855
Patent Document 2: Japanese Patent No. 3418727
Patent Document 3: Japanese Unexamined Patent Application, First Publication No. 2017-156229
Patent Document 4: PCT International Publication No. WO2017/82307

### SUMMARY OF INVENTION

### Technical Problem

As a method of using a microchannel device or a BioMEMS device such as u-TAS, cells or the like flowing through a channel are often stained with fluorescence and observed.

However, the channel formed by patterning using a photosensitive adhesive of the related art emits autofluorescence, and the fluorescence observation is inhibited by the autofluorescence, which is a problem.

The present invention has been made in consideration of the above-described circumstances, and an object thereof is to provide a photosensitive resin composition capable of forming a pattern having high rectangularity, having satisfactory adhesiveness to another substrate, and reducing autofluorescence, a pattern formation method using the photosensitive resin composition, and a method for producing a laminate using the pattern formation method.

### Solution to Problem

In order to solve the above-described problems, the present invention employs the following configurations.

That is, according to a first aspect of the present invention, there is provided a photosensitive resin composition including: a hydrogenated bisphenol A type epoxy resin (A1) having an epoxy equivalent of 600 or greater; and a photoacid generator (B1) represented by General Formula (b-1). 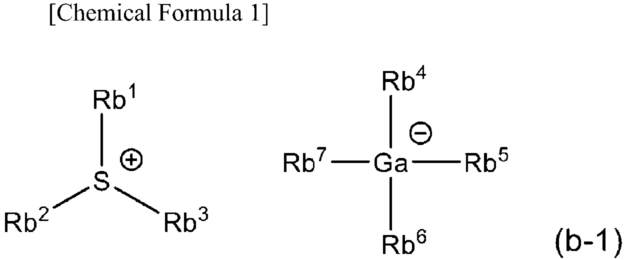 [In the formula, Rb¹ to Rb³ each independently represent an aryl group, a heteroaryl group, an alkyl group, or an alkenyl group, which may have a substituent. Here, Rb¹ to Rb³ have no fused ring. Rb⁴ to Rb⁷ each independently represent an aryl group which may have a substituent, or a fluorine atom.]

According to a second aspect of the present invention, there is provided a pattern formation method including: a step of forming a photosensitive resin film on a support using the negative type photosensitive resin composition according to the first aspect; a step of exposing the photosensitive resin film to light; and a step of developing the photosensitive resin film exposed to light with a developing solution containing an organic solvent, to form a negative type pattern.

According to a third aspect of the present invention, there is provided a method for producing a laminate, including: a step of obtaining a support having a pattern by the pattern formation method according to the second aspect; and a step of bonding the support having the pattern to another support by thermocompression bonding to obtain a laminate.

### Advantageous Effects of Invention

According to the present invention, it is possible to provide a photosensitive resin composition capable of forming a pattern having high rectangularity, having satisfactory adhesiveness to another substrate, and reducing autofluorescence, a pattern formation method using the photosensitive resin composition, and a method for producing a laminate using the pattern formation method.

### DESCRIPTION OF EMBODIMENTS

In the present specification and the scope of the present claims, the term "aliphatic" is a relative concept used in relation to the term "aromatic", and denotes a group, a compound, or the like that has no aromaticity.

The term "alkyl group" includes a linear, branched, or cyclic monovalent saturated hydrocarbon group unless otherwise specified. The same applies to the alkyl group in an alkoxy group.

The term "alkylene group" includes a linear, branched chain-like, or cyclic divalent saturated hydrocarbon group unless otherwise specified.

The term "halogenated alkyl group" denotes a group in which some or all hydrogen atoms of an alkyl group have been substituted with halogen atoms. Examples of the halogen atom include a fluorine atom, a chlorine atom, a bromine atom, and an iodine atom.

The term "fluorinated alkyl group" denotes a group in which some or all hydrogen atoms of an alkyl group have been substituted with fluorine atoms.

The term "constitutional unit" indicates a monomer unit constituting a polymer compound (a resin, a polymer, or a copolymer).

The expression "may have a substituent" includes both a case where a hydrogen atom (-H) is substituted with a monovalent group and a case where a methylene (-CH₂-) group is substituted with a divalent group.

The term "light exposure" is a general concept for irradiation with radiation.

### (Photosensitive resin composition)

A photosensitive resin composition of the present embodiment contains a hydrogenated bisphenol A type epoxy resin (A1) having an epoxy equivalent of 600 or greater (hereinafter, also referred to as "component (A1)") and a photoacid generator (B1) represented by General Formula (b-1) (hereinafter, also referred to as "component (B1)").

In a case where a photosensitive film is formed of such a photosensitive resin composition and selective exposure is performed on the photosensitive film, since a cation moiety of the component (B1) is decomposed to generate an acid in an exposed portion of the photosensitive film, and an epoxy group in the component (A1) is subjected to ring-opening polymerization due to an action of the acid so that solubility of the component (A1) in a developing solution containing an organic solvent is decreased while the solubility of the component (A1) in the developing solution containing an organic solvent is not changed in an unexposed portion of the photosensitive film. Therefore, a difference in solubility in the developing solution containing an organic solvent occurs between the exposed portion of the photosensitive film and the unexposed portion of the photosensitive film. Accordingly, in a case where the photosensitive film is developed with the developing solution containing an organic solvent, the unexposed portion is dissolved and removed so that a negative pattern is formed.

### (Component (A): epoxy group-containing compound)

In the photosensitive resin composition of the present embodiment, the component (A) contains at least a hydrogenated bisphenol A type epoxy resin (A1) having an epoxy equivalent of 600 or greater.

(Component (A1): hydrogenated bisphenol A type epoxy resin having epoxy equivalent weight of 600 or greater)

The component (A1) is a hydrogenated bisphenol A type epoxy resin having an epoxy equivalent (g/eq) of 600 or greater and being a solid at room temperature.

The epoxy equivalent of the component (A1) is preferably 700 or greater, more preferably 800 or greater, and still more preferably 900 or greater.

In a case where the epoxy equivalent of the component (A1) is in the above-described preferable ranges, the rectangularity of a pattern formed by using the photosensitive resin composition is likely to be high.

The upper limit of the epoxy equivalent of the component (A1) is not particularly limited, but is, for example, 2000 or less.

In the present embodiment, it is preferable that the component (A1) contains a resin (Aep-1) represented by General Formula (Aep-1). 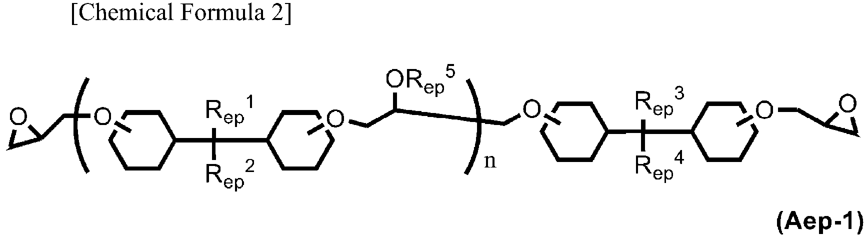 [In the formula, Rep¹ to Rep⁴ each independently represent a hydrogen atom, an alkyl group having 1 to 4 carbon atoms, or a trifluoromethyl group. Rep⁵ represents a hydrogen atom or a glycidyl group, and in a case where a plurality of Rep⁵'s are present, Rep⁵'s may be the same as or different from each other. n represents an integer of 0 or greater.]

In General Formula (Aep-1), Rep¹ to Rep⁴ each independently represent a hydrogen atom, an alkyl group having 1 to 4 carbon atoms, or a trifluoromethyl group. Rep¹ to Rep⁴ represent preferably an alkyl group having 1 to 4 carbon atoms and more preferably a methyl group.

In General Formula (Aep-1), Rep⁵ represents a hydrogen atom or a glycidyl group and preferably a hydrogen atom.

In General Formula (Aep-1), n represents an integer of 0 or greater, preferably 1 to 20, and more preferably 3 to 10.

### (Epoxy group-containing compound other than component (A1))

The photosensitive resin composition of the present embodiment may contain an epoxy group-containing compound (hereinafter, also referred to as "component (A2)") other than the component (A1).

Examples of the component (A2) include a bisphenol type epoxy resin (a bisphenol A type epoxy resin or a bisphenol F type epoxy resin), an acrylic resin, and an aliphatic epoxy resin.

As the bisphenol type epoxy resin, an epoxy resin having a structure represented by General Formula (abp1) is an exemplary example. 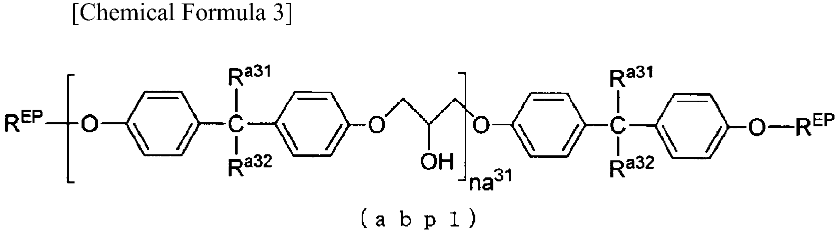 [In the formula, R^{EP} represents an epoxy group-containing group, R^{a31} and R^{a32} each independently represent a hydrogen atom or an alkyl group having 1 to 5 carbon atoms, and na³¹ represents an integer of 1 to 50.]

In Formula (abp1), the alkyl group having 1 to 5 carbon atoms as R^{a31} and R^{a32} has the same definition as that for R^{p1} and R^{p2} in Formula (Ap-1). Among these, it is preferable that R^{a31} and R^{a32} represent a hydrogen atom or a methyl group.

R^{EP} has the same definition as that for R^{EP} in Formula (Ap-1), and it is preferable that R^{EP} represents a glycidyl group.

As the acrylic resin, for example, a resin having an epoxy group-containing unit represented by General Formula (al-1) or (a1-2) is an exemplary example. 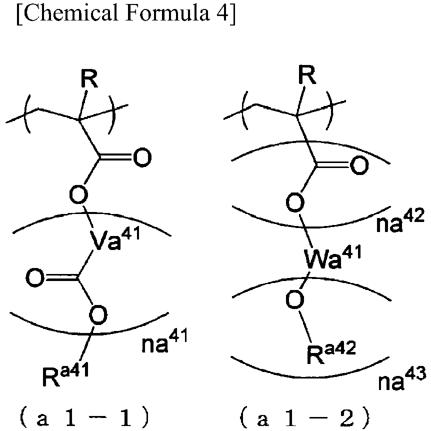 [In the formula, R represents a hydrogen atom, an alkyl group having 1 to 5 carbon atoms, or a halogenated alkyl group having 1 to 5 carbon atoms. Va⁴¹ represents a divalent hydrocarbon group which may have a substituent. na⁴¹ represents an integer of 0 to 2. R^{a41} and R^{a42} represent an epoxy group-containing group. na⁴² represents 0 or 1. Wa⁴¹ represents an (na⁴³ + 1)-valent aliphatic hydrocarbon group. na⁴³ represents an integer of 1 or 2.]

In Formula (a1-1), R represents a hydrogen atom, an alkyl group having 1 to 5 carbon atoms, or a halogenated alkyl group having 1 to 5 carbon atoms.

It is preferable that the alkyl group having 1 to 5 carbon atoms as R is a linear or branched chain-like alkyl group, and specific examples thereof include a methyl group, an ethyl group, a propyl group, an isopropyl group, an n-butyl group, an isobutyl group, a tert-butyl group, a pentyl group, an isopentyl group, and a neopentyl group.

The halogenated alkyl group having 1 to 5 carbon atoms as R is a group in which some or all hydrogen atoms in the alkyl group having 1 to 5 carbon atoms have been substituted with halogen atoms. Examples of the halogen atom include a fluorine atom, a chlorine atom, a bromine atom, and an iodine atom. Among these, a fluorine atom is particularly preferable.

R represents preferably a hydrogen atom, an alkyl group having 1 to 5 carbon atoms, or a fluorinated alkyl group having 1 to 5 carbon atoms and most preferably a hydrogen atom or a methyl group from the viewpoint of the industrial availability.

In Formula (a1-1), Va⁴¹ represents a divalent hydrocarbon group which may have a substituent, and examples thereof include the same groups as those for the divalent hydrocarbon group which may have a substituent, described in the section of R^{EP} in Formula (Ap-1).

Among these, the hydrocarbon group as Va⁴¹ is preferably an aliphatic hydrocarbon group, more preferably a linear or branched chain-like aliphatic hydrocarbon group, still more preferably a linear aliphatic hydrocarbon group, and particularly preferably a linear alkylene group.

In Formula (a1-1), na⁴¹ represents an integer of 0 to 2 and preferably 0 or 1.

In Formulae (a1-1) and (a1-2), R^{a41} and R^{a42} represent an epoxy group-containing group.

The epoxy group-containing group as R^{a41} and R^{a42} is not particularly limited, and examples thereof include a group consisting only of an epoxy group, a group consisting only of an alicyclic epoxy group, and a group containing an epoxy group or an alicyclic epoxy group and a divalent linking group.

The alicyclic epoxy group is an alicyclic group having an oxacyclopropane structure as a 3-membered ring ether. Specifically, the alicyclic epoxy group is a group having an alicyclic group and an oxacyclopropane structure.

An alicyclic group which is a basic skeleton of the alicyclic epoxy group may be monocyclic or polycyclic. As the monocyclic alicyclic group, a cyclopropyl group, a cyclobutyl group, a cyclopentyl group, a cyclohexyl group, a cycloheptyl group, and a cyclooctyl group are exemplary examples. In addition, as the polycyclic alicyclic group, a norbornyl group, an isobornyl group, a tricyclononyl group, a tricyclodecyl group, and a tetracyclododecyl group are exemplary examples. In addition, hydrogen atoms in these alicyclic groups may be substituted with an alkyl group, an alkoxy group, a hydroxyl group, or the like.

In a case of the group containing an epoxy group or an alicyclic epoxy group and a divalent linking group, it is preferable that the epoxy group or the alicyclic epoxy group is bonded via the divalent linking group bonded to an oxygen atom (-O-) in the formula.

Here, the divalent linking group is not particularly limited, and a divalent hydrocarbon group which may have a substituent and a divalent linking group having a heteroatom are suitable exemplary examples.

In regard to divalent hydrocarbon group which may have substituent:
Such a divalent hydrocarbon group may be an aliphatic hydrocarbon group or an aromatic hydrocarbon group.

The aliphatic hydrocarbon group in the divalent hydrocarbon group may be saturated or unsaturated, and in general, it is preferable that the aliphatic hydrocarbon group is saturated.

More specific examples of the aliphatic hydrocarbon group include a linear or branched aliphatic hydrocarbon group and an aliphatic hydrocarbon group having a ring in the structure thereof.

The linear aliphatic hydrocarbon group has preferably 1 to 10 carbon atoms, more preferably 1 to 6 carbon atoms, still more preferably 1 to 4 carbon atoms, and most preferably 1 to 3 carbon atoms. As the linear aliphatic hydrocarbon group, a linear alkylene group is preferable. Specific examples thereof include a methylene group [-CH₂-], an ethylene group [-(CH₂)₂-], a trimethylene group [-(CH₂)₃-], a tetramethylene group [-(CH₂)₄-], and a pentamethylene group [-(CH₂)₅-1.

The branched aliphatic hydrocarbon group has preferably 2 to 10 carbon atoms, more preferably 2 to 6 carbon atoms, still more preferably 2 to 4 carbon atoms, and most preferably 2 or 3 carbon atoms. As the branched aliphatic hydrocarbon group, a branched alkylene group is preferable, and specific examples thereof include alkylalkylene groups, for example, alkylmethylene groups such as -CH(CH₃)-, - CH(CH₂CH₃)-, -C(CH₃)₂-, -C(CH₃)(CH₂CH₃)-, -C(CH₃)(CH₂CH₂CH₃)-, and - C(CH₂CH₃)₂-; alkylethylene groups such as -CH(CH₃)CH₂-, -CH(CH₃)CH(CH₃)-, - C(CH₃)₂CH₂-, -CH(CH₂CH₃)CH₂-, and -C(CH₂CH₃)₂-CH₂-; alkyltrimethylene groups such as -CH(CH₃)CH₂CH₂- and -CH₂CH(CH₃)CH₂-; and alkyltetramethylene groups such as -CH(CH₃)CH₂CH₂CH₂- and -CH₂CH(CH₃)CH₂CH₂-. As the alkyl group in the alkylalkylene group, a linear alkyl group having 1 to 5 carbon atoms is preferable.

Examples of the aliphatic hydrocarbon group having a ring in the structure thereof include an alicyclic hydrocarbon group (a group in which two hydrogen atoms have been removed from an aliphatic hydrocarbon ring), a group in which the alicyclic hydrocarbon group is bonded to the terminal of the linear or branched aliphatic hydrocarbon group, and a group in which the alicyclic hydrocarbon group is interposed in the middle of the linear or branched aliphatic hydrocarbon group. Examples of the linear or branched aliphatic hydrocarbon group include the same groups as those described above.

The number of carbon atoms in the alicyclic hydrocarbon group is preferably 3 to 20 and more preferably 3 to 12.

The alicyclic hydrocarbon group may be a polycyclic group or a monocyclic group. As the monocyclic alicyclic hydrocarbon group, a group formed by removing two hydrogen atoms from a monocycloalkane is preferable. The monocycloalkane has preferably 3 to 6 carbon atoms, and specific examples thereof include cyclopentane and cyclohexane.

As the polycyclic alicyclic hydrocarbon group, a group formed by removing two hydrogen atoms from a polycycloalkane is preferable. The number of carbon atoms in the polycycloalkane is preferably 7 to 12, and specific examples thereof include adamantane, norbornane, isobornane, tricyclodecane, and tetracyclododecane.

The aromatic hydrocarbon group in the divalent hydrocarbon group is a hydrocarbon group having at least one aromatic ring. The aromatic ring is not particularly limited as long as the aromatic ring is a cyclic conjugated system having (4n + 2) π electrons and may be monocyclic or polycyclic. The aromatic ring has preferably 5 to 30 carbon atoms, more preferably 5 to 20 carbon atoms, still more preferably 6 to 15 carbon atoms, and particularly preferably 6 to 12 carbon atoms. Specific examples of the aromatic ring include aromatic hydrocarbon rings such as benzene, naphthalene, anthracene, and phenanthrene, and aromatic heterocyclic rings in which some carbon atoms constituting the above-described aromatic hydrocarbon rings have been substituted with heteroatoms. Examples of the heteroatom in the aromatic heterocyclic rings include an oxygen atom, a sulfur atom, and a nitrogen atom. Specific examples of the aromatic heterocyclic ring include a pyridine ring and a thiophene ring.

Specific examples of the aromatic hydrocarbon group include a group in which two hydrogen atoms have been removed from the above-described aromatic hydrocarbon ring or aromatic heterocyclic ring (an arylene group or a heteroarylene group), a group in which two hydrogen atoms have been removed from an aromatic compound having two or more aromatic rings (such as biphenyl or fluorene), and a group in which one hydrogen atom of a group (an aryl group or a heteroaryl group) obtained by removing one hydrogen atom from the above-described aromatic hydrocarbon ring or aromatic heterocyclic ring has been substituted with an alkylene group (for example, a group obtained by further removing one hydrogen atom from an aryl group in an arylalkyl group such as a benzyl group, a phenethyl group, a 1-naphthylmethyl group, a 2-naphthylmethyl group, a 1-naphthylethyl group, or a 2-naphthylethyl group). The alkylene group bonded to the aryl group or the heteroaryl group has preferably 1 to 4 carbon atoms, more preferably 1 or 2 carbon atoms, and particularly preferably 1 carbon atom.

Among these, from the viewpoint of reducing autofluorescence, an aromatic hydrocarbon group which has no fused ring is preferable as the aromatic hydrocarbon group in the divalent hydrocarbon group.

The divalent hydrocarbon group may have a substituent.

The linear or branched aliphatic hydrocarbon group as the divalent hydrocarbon group may or may not have a substituent. Examples of the substituent include a fluorine atom, a fluorinated alkyl group having 1 to 5 carbon atoms which has been substituted with a fluorine atom, and a carbonyl group.

The alicyclic hydrocarbon group in the aliphatic hydrocarbon group including a ring in the structure thereof, as the divalent hydrocarbon group, may or may not have a substituent. As the substituent, an alkyl group, an alkoxy group, a halogen atom, a halogenated alkyl group, a hydroxyl group, and a carbonyl group are exemplary examples.

As the alkyl group as the substituent, an alkyl group having 1 to 5 carbon atoms is preferable, and a methyl group, an ethyl group, a propyl group, an n-butyl group, or a tert-butyl group is most preferable.

As the alkoxy group as the substituent, an alkoxy group having 1 to 5 carbon atoms is preferable, a methoxy group, an ethoxy group, an n-propoxy group, an iso-propoxy group, an n-butoxy group, or a tert-butoxy group is preferable, and a methoxy group or an ethoxy group is most preferable.

Examples of the halogen atom as the substituent include a fluorine atom, a chlorine atom, a bromine atom, and an iodine atom. Among these, a fluorine atom is preferable.

Examples of the halogenated alkyl group as the substituent include groups in which some or all hydrogen atoms in the above-described alkyl groups have been substituted with the above-described halogen atoms.

In the alicyclic hydrocarbon group, some carbon atoms constituting the ring structure thereof may be substituted with a substituent having a heteroatom. As the substituent having a heteroatom, -O-, -C(=O)-O-, -S-, -S(=O)₂-, or -S(=O)₂-O- is preferable.

In the aromatic hydrocarbon group as the divalent hydrocarbon group, a hydrogen atom in the aromatic hydrocarbon group may be substituted with a substituent. For example, the hydrogen atom bonded to the aromatic ring in the aromatic hydrocarbon group may be substituted with a substituent. As the substituent, an alkyl group, an alkoxy group, a halogen atom, a halogenated alkyl group, and a hydroxyl group are exemplary examples.

As the alkyl group as the substituent, an alkyl group having 1 to 5 carbon atoms is preferable, and a methyl group, an ethyl group, a propyl group, an n-butyl group, or a tert-butyl group is most preferable.

Examples of the alkoxy group, the halogen atom, and the halogenated alkyl group as the above-described substituent include the same groups described as the substituent which substitutes the hydrogen atom in the alicyclic hydrocarbon group.

In regard to divalent linking group having heteroatom:
The heteroatom in the divalent linking group having a heteroatom is an atom other than a carbon atom and a hydrogen atom, and examples thereof include an oxygen atom, a nitrogen atom, a sulfur atom, and a halogen atom.

In the divalent linking group having a heteroatom, preferred examples of the linking group include -O-, -C(=O)-O-, -C(=O)-, -O-C(=O)-O-; -C(=O)-NH-, -NH-, -NH-C(=O)-O-, -NH-C(=NH)- (H may be substituted with a substituent such as an alkyl group or an acyl group); -S-, -S(=O)₂-, -S(=O)₂-O-, and a group represented by General Formula -Y²¹-O-Y²²-, -Y²¹-O-, -Y²¹-C(=O)-O-, -C(=O)-O-Y²¹-, -[Y²¹-C(=O)-O]_{m"}-Y²²-, or -Y²¹-O-C(=O)-Y²²- [in the formulae, Y²¹ and Y²² each independently represent a divalent hydrocarbon group which may have a substituent, O represents an oxygen atom, and m" represents an integer of 0 to 3].

In a case where the divalent linking group having a heteroatom is -C(=O)-NH-, - NH-, -NH-C(=O)-O-, or -NH-C(=NH)-, H may be substituted with a substituent such as an alkyl group or an acyl group. The substituent (alkyl group, acyl group, or the like) has preferably 1 to 10 carbon atoms, more preferably 1 to 8 carbon atoms, and particularly preferably 1 to 5 carbon atoms.

In Formulae -Y²¹-O-Y²²-, -Y²¹-O-, -Y²¹-C(=O)-O-, -C(=O)-O-Y²¹-, -[Y²¹-C(=O)-O]_{m"}-Y²²-, and -Y²¹-O-C(=O)-Y²²-, Y²¹ and Y²² each independently represent a divalent hydrocarbon group which may have a substituent. Examples of the divalent hydrocarbon group include the same groups as those described in the section of "divalent hydrocarbon group which may have a substituent" as the divalent linking group.

Y²¹ represents preferably a linear aliphatic hydrocarbon group, more preferably a linear alkylene group, still more preferably a linear alkylene group having 1 to 5 carbon atoms, and particularly preferably a methylene group or an ethylene group.

Y²² represents preferably a linear or branched aliphatic hydrocarbon group and more preferably a methylene group, an ethylene group, or an alkylmethylene group. The alkyl group in the alkylmethylene group is preferably a linear alkyl group having 1 to 5 carbon atoms, more preferably a linear alkyl group having 1 to 3 carbon atoms, and most preferably a methyl group.

In the group represented by Formula -[Y²¹-C(=O)-O]_{m"}-Y²²-, m" represents an integer of 0 to 3, preferably an integer of 0 to 2, more preferably 0 or 1, and particularly preferably 1. That is, a group represented by Formula -Y²¹-C(=O)-O-Y²²- is particularly preferable as the group represented by Formula -[Y²¹-C(=O)-O]_{m"}-Y²²-. Among these, a group represented by Formula -(CH₂)_{a'}-C(=O)-O-(CH₂)_{b'}- is preferable. In the formula, a' represents an integer of 1 to 10, preferably an integer of 1 to 8, more preferably an integer of 1 to 5, still more preferably 1 or 2, and most preferably 1. b' represents an integer of 1 to 10, preferably an integer of 1 to 8, more preferably an integer of 1 to 5, still more preferably 1 or 2, and most preferably 1.

Among these, a glycidyl group is preferable as the epoxy group-containing group as R^{a41} and R^{a42}.

In Formula (a1-2), an (na⁴³+1)-valent aliphatic hydrocarbon group as Wa⁴¹ denotes a hydrocarbon group having no aromaticity and may be saturated or unsaturated. In general, it is preferable that the aliphatic hydrocarbon group is saturated. Examples of the aliphatic hydrocarbon group include a linear or branched chain-like aliphatic hydrocarbon group, an aliphatic hydrocarbon group having a ring in the structure thereof, and a group obtained by combining the linear or branched chain-like aliphatic hydrocarbon group and the aliphatic hydrocarbon group having a ring in the structure thereof.

Further, the acrylic resin in the above-described component (A) may have a constitutional unit derived from other polymerizable compounds for the purpose of appropriately controlling physical and chemical characteristics. As such a polymerizable compound, known radical polymerizable compounds and anionic polymerizable compounds are exemplary examples. Examples of such polymerizable compounds include monocarboxylic acids such as acrylic acid, methacrylic acid, and crotonic acid, dicarboxylic acids such as maleic acid, fumaric acid, and itaconic acid, methacrylic acid derivatives containing a carboxyl group and an ester bond such as 2-methacryloyloxyethylsuccinic acid, 2-methacryloyloxyethylmaleic acid, 2-methacryloyloxyethylphthalic acid, and 2-methacryloyloxyethylhexahydrophthalic acid, (meth)acrylic acid alkyl esters such as methyl (meth)acrylate, ethyl (meth)acrylate, and butyl (meth)acrylates, (meth)acrylic acid hydroxy alkyl esters such as 2-hydroxyethyl (meth)acrylate and 2-hydroxypropyl (meth)acrylate, (meth)acrylic acid aryl ester such as phenyl (meth)acrylate and benzyl (meth)acrylate, dicarboxylic acid diesters such as diethyl maleate and dibutyl fumarate; vinyl group-containing aromatic compounds such as styrene, α-methylstyrene, chlorostyrene, chloromethylstyrene, vinyltoluene, hydroxystyrene, α-methylhydroxystyrene, and α-ethylhydroxystyrene, vinyl group-containing aliphatic compounds such as vinyl acetate; conjugated diolefins such as butadiene and isoprene; nitrile group-containing polymerizable compounds such as acrylonitrile and methacrylonitrile, chlorine-containing polymerizable compounds such as vinyl chloride and vinylidene chloride, and amide bond-containing polymerizable compounds such as acrylamide and methacrylamide.

Suitable examples of the aliphatic epoxy resin also include a compound (hereinafter, also referred to as "component (m1)") having a partial structure represented by General Formula (m1). 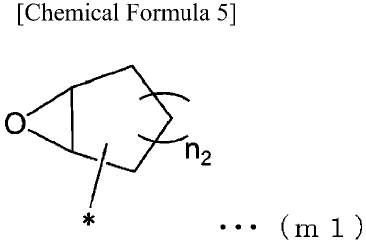 [In the formula, n₂ represents an integer of 1 to 4. * represents a bonding site.]

In Formula (m1), n₂ represents an integer of 1 to 4, preferably an integer of 1 to 3, and more preferably 2.

Examples of the component (m1) include a compound in which a plurality of partial structures represented by General Formula (m1) are bonded via a divalent linking group or a single bond. Among these, a compound in which a plurality of partial structures represented by General Formula (m1) are bonded via a divalent linking group is preferable.

The divalent linking group here is not particularly limited, and suitable examples thereof include a divalent hydrocarbon group which may have a substituent and a divalent linking group having a heteroatom. The divalent hydrocarbon group which may have a substituent and the divalent linking group having a heteroatom are the same as the divalent hydrocarbon group which may have a substituent and the divalent linking group having a heteroatom, described in the section of R^{a41} and R^{a42} (epoxy group-containing group) in Formulae (a1-1) and (a1-2). Among these, the divalent linking group having a heteroatom is preferable, and a group represented by -Y²¹-C(=O)-O- or a group represented by -C(=O)-O-Y²¹- is more preferable. Y²¹ represents preferably a linear aliphatic hydrocarbon group, more preferably a linear alkylene group, still more preferably a linear alkylene group having 1 to 5 carbon atoms, and particularly preferably a methylene group or an ethylene group.

In the photosensitive resin composition of the present embodiment, the content of the component (A1) is preferably 50% by mass or greater, more preferably 70% by mass or greater, and still more preferably 85% by mass or greater, and may be 100% by mass with respect to the total amount of the epoxy group-containing compound contained in the photosensitive resin composition.

In a case where the content of the component (A1) is in the above-described preferable ranges, the rectangularity of a pattern formed by using the photosensitive resin composition is likely to be high.

The mass average molecular weight of the component (A) in terms of polystyrene is preferably 100 to 300000, more preferably 200 to 200000, and still more preferably 300 to 200000. In a case where the mass average molecular weight thereof is in the above-described ranges, peeling from the support is unlikely to occur, and hardness of a cured film to be formed is sufficiently increased.

In addition, a dispersity of the component (A) is preferably 1.05 or greater. By setting the dispersity thereof to such a value, lithography characteristics in pattern formation are further improved.

The dispersity here denotes a value obtained by dividing the mass average molecular weight by the number-average molecular weight.

The content of the component (A) in the photosensitive resin composition according to the embodiment may be adjusted according to the film thickness and the like of the photosensitive film intended to be formed.

### (Component (B1): photoacid generator represented by General Formula (b-1))

The component (B1) is a photoacid generator represented by General Formula (b-1). 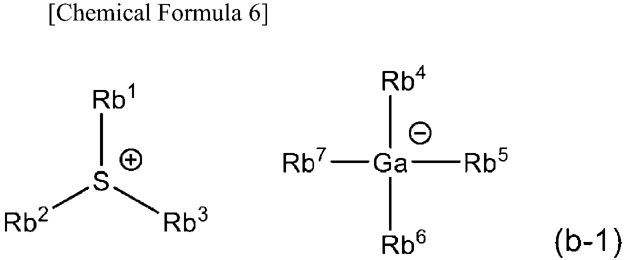 [In the formula, Rb¹ to Rb³ each independently represent an aryl group, a heteroaryl group, an alkyl group, or an alkenyl group, which may have a substituent. Here, Rb¹ to Rb³ have no fused ring. Rb⁴ to Rb⁷ each independently represent an aryl group which may have a substituent, or a fluorine atom.]

### (Cation moiety of component (B1))

In General Formula (b-1), examples of the aryl group as Rb¹ to Rb³ include an unsubstituted aryl group having 6 to 20 carbon atoms. Among examples, a phenyl group or a biphenyl group is preferable.

Examples of the heteroaryl group as Rb¹ to Rb³ include a group in which some of the carbon atoms constituting the aryl group are substituted with heteroatoms. Examples of the heteroatoms include an oxygen atom, a sulfur atom, and a nitrogen atom. Examples of the heteroaryl group include a diarylthioether group and a diaryl ether group.

The alkyl group as Rb¹ to Rb³ is preferably a chain-like or cyclic alkyl group which has 1 to 30 carbon atoms.

It is preferable that the alkenyl group as Rb¹ to Rb³ has 2 to 10 carbon atoms.

Examples of the substituent that Rb¹ to Rb³ may have include an alkyl group, a halogen atom, a halogenated alkyl group, a carbonyl group, a cyano group, an amino group, an oxo group (=O), an aryl group, and groups each represented by Formulae (ca-r-1) to (ca-r-10). 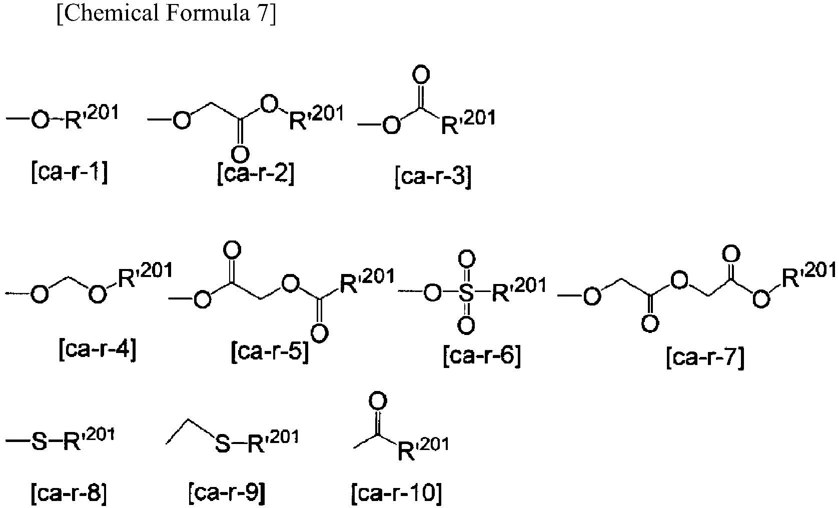 [In the formulae, R'²⁰¹'s each independently represent a hydrogen atom, a cyclic group which may have a substituent, a chain-like alkyl group which may have a substituent, or a chain-like alkenyl group which may have a substituent.]

In Formulae (ca-r-1) to (ca-r-10), R'²⁰¹'s each independently represent a hydrogen atom, a cyclic group which may have a substituent, a chain-like alkyl group which may have a substituent, or a chain-like alkenyl group which may have a substituent.

Cyclic group which may have substituent:
The cyclic group is preferably a cyclic hydrocarbon group, and the cyclic hydrocarbon group may be an aromatic hydrocarbon group or a cyclic aliphatic hydrocarbon group. The aliphatic hydrocarbon group indicates a hydrocarbon group that has no aromaticity. Further, the aliphatic hydrocarbon group may be saturated or unsaturated. In general, it is preferable that the aliphatic hydrocarbon group is saturated.

The aromatic hydrocarbon group as R'²⁰¹ is a hydrocarbon group having an aromatic ring. The number of carbon atoms in the aromatic hydrocarbon group is preferably 3 to 30, more preferably 5 to 30, still more preferably 5 to 20, particularly preferably 6 to 15, and most preferably 6 to 10. Here, the number of carbon atoms does not include the number of carbon atoms in a substituent.

Specific examples of the aromatic ring in the aromatic hydrocarbon group represented by R'²⁰¹ include benzene, fluorene, naphthalene, anthracene, phenanthrene, biphenyl, an aromatic heterocyclic ring in which some of the carbon atoms constituting any of these aromatic rings are substituted with heteroatom, and a ring in which some of the hydrogen atoms constituting any of these aromatic rings or aromatic heterocyclic rings are substituted with oxo groups. Examples of the heteroatom in the aromatic heterocyclic rings include an oxygen atom, a sulfur atom, and a nitrogen atom.

Specific examples of the aromatic hydrocarbon group represented by R'²⁰¹ include a group (an aryl group such as a phenyl group, a naphthyl group, or an anthracenyl group) formed by removing one hydrogen atom from the aromatic ring, a group (for example, an arylalkyl group such as a benzyl group, a phenethyl group, a 1-naphthylmethyl group, a 2-naphthylmethyl group, a 1-naphthylethyl group, or a 2-naphthylethyl group) in which one hydrogen atom in the aromatic ring is substituted with an alkylene group, a group formed by removing one hydrogen atom from a ring (such as anthraquinone) in which some hydrogen atoms constituting the aromatic ring is substituted with oxo groups and the like, and a group formed by removing one hydrogen atom from an aromatic heterocyclic ring (such as 9H-thioxanthene or 9H-thioxanthen-9-one). The alkylene group (alkyl chain in the arylalkyl group) has preferably 1 to 4 carbon atoms, more preferably 1 or 2 carbon atoms, and particularly preferably 1 carbon atom.

Examples of the cyclic aliphatic hydrocarbon group as R'²⁰¹ include an aliphatic hydrocarbon group having a ring in the structure thereof.

Examples of the aliphatic hydrocarbon group having a ring in the structure thereof include an alicyclic hydrocarbon group (group in which one hydrogen atom has been removed from an aliphatic hydrocarbon ring), a group in which the alicyclic hydrocarbon group is bonded to the terminal of a linear or branched aliphatic hydrocarbon group, and a group in which the alicyclic hydrocarbon group is interposed in the middle of a linear or branched aliphatic hydrocarbon group.

The alicyclic hydrocarbon group has preferably 3 to 20 carbon atoms and more preferably 3 to 12 carbon atoms.

The alicyclic hydrocarbon group may be a polycyclic group or a monocyclic group. As the monocyclic alicyclic hydrocarbon group, a group in which one or more hydrogen atoms have been removed from a monocycloalkane is preferable. The monocycloalkane has preferably 3 to 6 carbon atoms, and specific examples thereof include cyclopentane and cyclohexane. As the polycyclic alicyclic hydrocarbon group, a group in which one or more hydrogen atoms have been removed from a polycycloalkane is preferable, and the number of carbon atoms of the polycycloalkane is preferably in a range of 7 to 30. Among these, a polycycloalkane having a crosslinked ring-based polycyclic skeleton such as adamantane, norbornane, isobornane, tricyclodecane, or tetracyclododecane, and a polycycloalkane having a condensed ring-based polycyclic skeleton such as a cyclic group having a steroid skeleton are preferable as the polycycloalkane.

Among these examples, as the cyclic aliphatic hydrocarbon group as R'²⁰¹, a group in which one or more hydrogen atoms have been removed from a monocycloalkane or a polycycloalkane is preferable, a group in which one hydrogen atom has been removed from a polycycloalkane is more preferable, an adamantyl group or a norbornyl group is particularly preferable, and an adamantyl group is most preferable.

The number of carbon atoms in the linear or branched aliphatic hydrocarbon group which may be bonded to the alicyclic hydrocarbon group is preferably 1 to 10, more preferably 1 to 6, still more preferably 1 to 4, and most preferably 1 to 3.

As the linear aliphatic hydrocarbon group, a linear alkylene group is preferable. Specific examples thereof include a methylene group [-CH₂-], an ethylene group [-(CH₂)₂-], a trimethylene group [-(CH₂)₃-], a tetramethylene group [-(CH₂)₄-], and a pentamethylene group [-(CH₂)₅-].

As the branched aliphatic hydrocarbon group, a branched alkylene group is preferable, and specific examples thereof include alkylalkylene groups, for example, alkylmethylene groups such as -CH(CH₃)-, -CH(CH₂CH₃)-, -C(CH₃)₂-, - C(CH₃)(CH₂CH₃)-, -C(CH₃)(CH₂CH₂CH₃)-, and -C(CH₂CH₃)₂-; alkylethylene groups such as -CH(CH₃)CH₂-, -CH(CH₃)CH(CH₃)-, -C(CH₃)₂CH₂-, -CH(CH₂CH₃)CH₂-, and - C(CH₂CH₃)₂-CH₂-; alkyltrimethylene groups such as -CH(CH₃)CH₂CH₂- and - CH₂CH(CH₃)CH₂-; and alkyltetramethylene groups such as -CH(CH₃)CH₂CH₂CH₂- and -CH₂CH(CH₃)CH₂CH₂-. As the alkyl group in the alkylalkylene group, a linear alkyl group having 1 to 5 carbon atoms is preferable.

Chain-like alkyl group which may have substituent:
The chain-like alkyl group as R'²⁰¹ may be linear or branched.

The number of carbon atoms in the linear alkyl group is preferably 1 to 20, more preferably 1 to 15, and most preferably 1 to 10. Specific examples thereof include a methyl group, an ethyl group, a propyl group, a butyl group, a pentyl group, a hexyl group, a heptyl group, an octyl group, a nonyl group, a decanyl group, an undecyl group, a dodecyl group, a tridecyl group, an isotridecyl group, a tetradecyl group, a pentadecyl group, a hexadecyl group, an isohexadecyl group, a heptadecyl group, an octadecyl group, a nonadecyl group, an icosyl group, a henicosyl group, and a docosyl group.

The number of carbon atoms in the branched alkyl group is preferably 3 to 20, more preferably 3 to 15, and most preferably 3 to 10. Specific examples thereof include a 1-methylethyl group, a 1-methylpropyl group, a 2-methylpropyl group, a 1-methylbutyl group, a 2-methylbutyl group, a 3-methylbutyl group, a 1-ethylbutyl group, a 2-ethylbutyl group, a 1-methylpentyl group, a 2-methylpentyl group, a 3-methylpentyl group, and a 4-methylpentyl group.

Chain-like alkenyl group which may have substituent:
The chain-like alkenyl group as R'²⁰¹ may be linear or branched, and the number of carbon atoms in the chain-like alkenyl group is preferably 2 to 10, more preferably 2 to 5, still more preferably 2 to 4, and particularly preferably 3. Examples of the linear alkenyl group include a vinyl group, a propenyl group (an allyl group), and a butynyl group. Examples of the branched alkenyl group include a 1-methylvinyl group, a 2-methylvinyl group, a 1-methylpropenyl group, and a 2-methylpropenyl group.

Among the examples, as the chain-like alkenyl group, a linear alkenyl group is preferable, a vinyl group or a propenyl group is more preferable, and a vinyl group is particularly preferable.

Examples of the substituent for the cyclic group, the chain-like alkyl group, or the chain-like alkenyl group as R'²⁰¹ include an alkoxy group, a halogen atom, a halogenated alkyl group, a hydroxyl group, a carbonyl group, a nitro group, an amino group, an oxo group, the cyclic group as R'²⁰¹, an alkylcarbonyl group, and a thienylcarbonyl group.

Among these, it is preferable that R'²⁰¹ represents a cyclic group which may have a substituent or a chain-like alkyl group which may have a substituent.

In a case where R²⁰¹ to R²⁰³, R²⁰⁶ and R²⁰⁷, or R²¹¹ and R²¹² are bonded to each other to form a ring together with the sulfur atom in the formula, these groups may be bonded to each other via a heteroatom such as a sulfur atom, an oxygen atom, or a nitrogen atom, or a functional group such as a carbonyl group, -SO-, -SO₂-, -SO₃-, - COO-, -CONH-, or -N(R_{N})- (here, R_{N} represents an alkyl group having 1 to 5 carbon atoms). As a ring to be formed, one ring having the sulfur atom in the formula in the ring skeleton thereof is preferably a 3- to 10-membered ring and particularly preferably a 5- to 7-membered ring, including the sulfur atom. Specific examples of the ring to be formed include a thiophene ring, a thiazole ring, a benzothiophene ring, a thianthrene ring, a benzothiophene ring, a dibenzothiophene ring, a 9H-thioxanthene ring, a thioxanthone ring, a thianthrene ring, a phenoxathiin ring, a tetrahydrothiophenium ring, and a tetrahydrothiopyranium ring.

### (Anion moiety of component (B1))

In Formula (b-1), the aryl group as Rb⁴ to Rb⁷ has preferably 5 to 30 carbon atoms, more preferably 5 to 20 carbon atoms, still more preferably 6 to 15 carbon atoms, and particularly preferably 6 to 12 carbon atoms. Specific examples thereof include a naphthyl group, a phenyl group, and an anthracenyl group. Among these, a phenyl group is preferable from the viewpoint of availability.

The aryl group as Rb⁴ to Rb⁷ may have a substituent. The substituent is not particularly limited. As the substituent, a halogen atom, a hydroxyl group, an alkyl group (preferably a linear or branched alkyl group having 1 to 5 carbon atoms), or a halogenated alkyl group is preferable, a halogen atom or a halogenated alkyl group having 1 to 5 carbon atoms is more preferable, and a fluorine atom or a fluorinated alkyl group having 1 to 5 carbon atoms is particularly preferable. It is preferable that the aryl group has a fluorine atom because the polarity of the anion moiety is increased.

Among the examples, Rb⁴ to Rb⁷ in Formula (b-1) each represent preferably a fluorinated phenyl group and particularly preferably a perfluorophenyl group.

From the viewpoint of reducing the autofluorescence of the photosensitive resin composition, it is preferable that the component (B1) is a compound represented by General Formula (b-1-1). 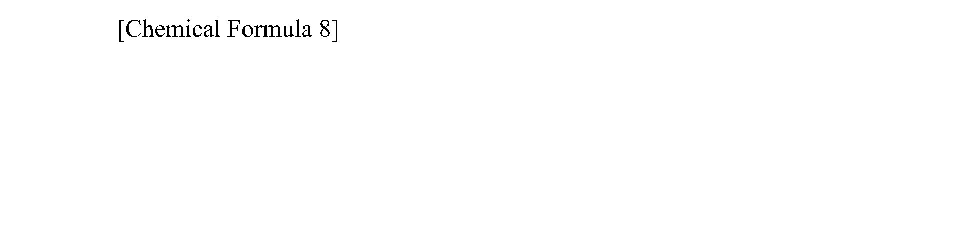 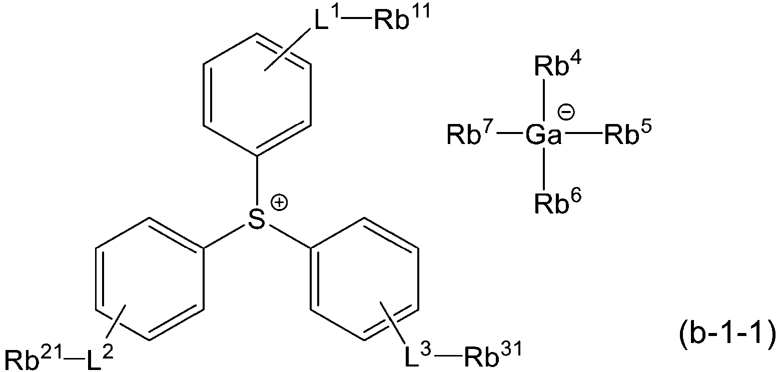 [In the formula, L¹, L², and L³ each independently represent a single bond or -S-. Rb¹¹, Rb²¹, and Rb³¹ each independently represent a phenyl group which may have a substituent or a hydrogen atom. Here, at least one of Rb¹¹, Rb²¹, and Rb³¹ represents a phenyl group which may have a substituent. Rb⁴ to Rb⁷ each independently represent an aryl group which may have a substituent, or a fluorine atom.]

In General Formula (b-1-1), examples of the substituent which may be contained in the phenyl group as Rb¹¹, Rb²¹, and Rb³¹ include an aryl group and an acyl group. Among these, the substituent which may be contained in the phenyl group as Rb¹¹, Rb²¹, and Rb³¹ is preferably a phenyl group or an acetyl group.

In General Formula (b-1-1), Rb⁴ to Rb⁷ each have the same definition as that for Rb⁴ to Rb⁷ in General Formula (b-1).

Specific suitable examples of the component (B1) are shown below.

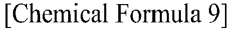

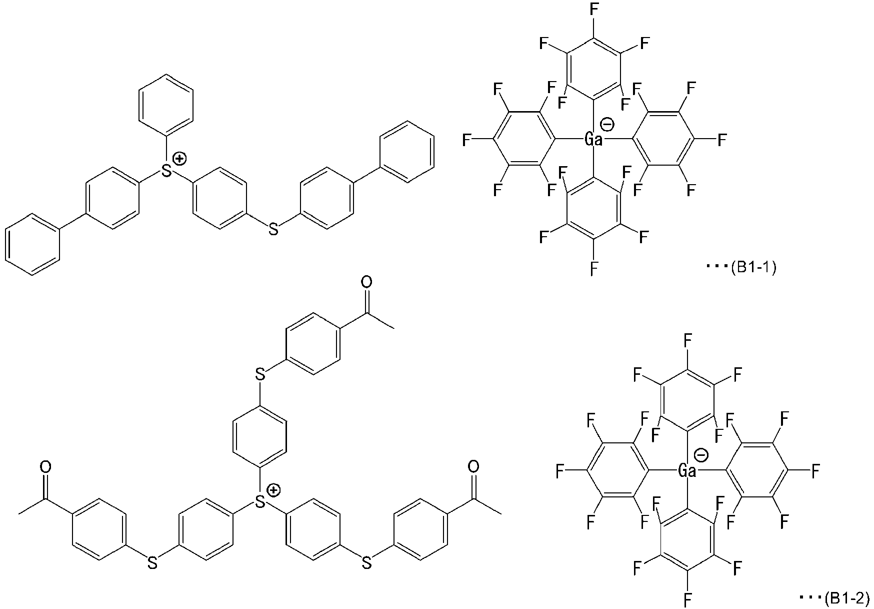

In the photosensitive resin composition of the present embodiment, the content of the component (B1) is preferably 0.01 to 10 parts by mass, more preferably 0.05 to 5 parts by mass, and still more preferably 0.1 to 3 parts by mass with respect to 100 parts by mass of the component (A1).

In a case where the content of the component (B1) is in the above-described preferable ranges, the autofluorescence of the photosensitive resin composition is likely to be reduced.

### <Other components>

The photosensitive resin composition according to the present embodiment may contain other components as necessary in addition to the component (A1) and the component (B1) described above.

As desired, miscible additives such as a silane coupling agent, a sensitizer component, a metal oxide (M), a solvent, an additive resin for improving film performance, a dissolution inhibitor, a basic compound, a plasticizer, a stabilizer, a colorant, and a halation-preventing agent can be appropriately added to the photosensitive resin composition of the embodiment.

### <<Silane coupling agent>>

The photosensitive resin composition according to the present embodiment may further contain an adhesion assistant in order to improve the adhesiveness to the substrate. A silane coupling agent is preferable as the adhesion assistant. That is, the photosensitive resin composition according to the present embodiment may further contain a silane coupling agent.

Examples of the silane coupling agent include silane coupling agents having reactive substituents such as a carboxy group, a methacryloyl group, an isocyanate group, and an epoxy group. Specific examples thereof include trimethoxysilylbenzoic acid, γ-methacryloxypropyltrimethoxysilane, vinyltriacetoxysilane, vinyltrimethoxysilane, γ-glycidoxypropyltrimethoxysilane, and β-(3,4-epoxycyclohexyl)ethyltrimethoxysilane.

The silane coupling agent may be used alone or in combination of two or more kinds thereof.

In a case where the photosensitive resin composition contains the silane coupling agent, the content thereof is preferably 0.1 to 10 parts by mass, more preferably 0.5 to 5 parts by mass, and still more preferably 1 to 3 parts by mass with respect to 100 parts by mass of the component (A).

In a case where the content of the silane coupling agent is in the above-described preferable ranges, the hardness of the cured film is further enhanced. In addition, the adhesiveness between the cured film and the substrate is further strengthened.

### <<Sensitizer component>>

The photosensitive resin composition according to the present embodiment may further contain a sensitizer component.

The sensitizer component is not particularly limited as long as the sensitizer component can absorb energy upon light exposure and transmit the energy to other substances.

Specifically, benzophenone-based photosensitizers such as benzophenone and p,p'-tetramethyldiaminobenzophenone, carbazole-based photosensitizers, acetophenone-based photosensitizers, naphthalene-based photosensitizers such as 1,5-dihydroxynaphthalene, phenol-based photosensitizers, anthracene-based photosensitizers such as 9,10-dibutoxyanthracene, 9,10-diethoxyanthracene, 9-ethoxyanthracene, and known photosensitizers such as biacetyl, eosin, rose bengal, pyrene, phenothiazine, and anthrone can be used as the sensitizer component.

Among these, from the viewpoint of reducing the autofluorescence, a compound having an aromatic ring that does not have a fused ring is preferable as the sensitizer component.

The sensitizer component may be used alone or in combination of two or more kinds thereof.

In a case where the photosensitive resin composition contains the sensitizer component, the content of the sensitizer component is preferably 0.1 to 10 parts by mass, more preferably 0.3 to 5 parts by mass, and still more preferably 0.5 to 3 parts by mass with respect to 100 parts by mass of the component (A).

In a case where the content of the sensitizer component is in the above-described preferable ranges, the sensitivity and the resolution are further enhanced.

### <<Metal oxide (M)>>

The photosensitive resin composition according to the present embodiment may contain a metal oxide (M) (hereinafter, also referred to as "component (M)") because a cured film with enhanced hardness is likely to be obtained. Further, in a case where the photosensitive resin composition contains the component (M) in combination with other components, a high-resolution pattern having a satisfactory shape can be formed.

Examples of the component (M) include oxides of metals such as silicon (metallic silicon), titanium, zirconium, and hafnium. Among these, an oxide of silicon is preferable. In addition, it is particularly preferable to use silica.

In addition, it is preferable that the component (M) is particulate.

As such a particulate component (M), a component consisting of a group of particles having a volume average particle diameter of 5 to 40 nm is preferable, a component consisting of a group of particles having a volume average particle diameter of 5 to 30 nm is more preferable, and a component consisting of a group of particles having a volume average particle diameter of 10 to 20 nm is still more preferable.

In a case where the volume average particle diameter of the component (M) is greater than or equal to the lower limit of the above-described preferable ranges, the hardness of the cured film is likely to be enhanced. Meanwhile, in a case where the volume average particle diameter of the component (M) is less than or equal to the upper limit of the above-described preferable ranges, residues are unlikely to be generated in the pattern formation, and a higher-resolution pattern is likely to be formed. In addition, the transparency of the resin film is enhanced.

The particle diameter of the component (M) may be appropriately selected according to the exposure light source. In general, it is considered that particles having a particle diameter of 1/10 or less of the wavelength of light are almost not affected by light scattering. Therefore, for example, in a case where a fine structure is formed by photolithography with i-line (365 nm), it is preferable that a group (particularly preferably a group of silica particles) consisting of particles having a primary particle diameter (volume average value) of 10 to 20 nm is used as the component (M).

The component (M) may be used alone or in combination of two or more kinds thereof.

In a case where the photosensitive resin composition contains the component (M), the content thereof is preferably 5 to 50 parts by mass and more preferably 10 to 40 parts by mass with respect to 100 parts by mass of the component (A).

In a case where the content of the component (M) is greater than or equal to the lower limit of the above-described preferable ranges, the hardness of the cured film is further enhanced. Meanwhile, in a case where the content of the component (M) is less than or equal to the upper limits of the above-described preferable ranges, the transparency of the resin film is further enhanced.

The photosensitive resin composition according to the present embodiment may further contain a solvent (hereinafter, also referred to as "component (S)").

Examples of the component (S) include lactones such as γ-butyrolactone, ketones such as acetone, methyl ethyl ketone (MEK), cyclohexanone, methyl-n-pentyl ketone, methyl isopentyl ketone, and 2-heptanone, polyhydric alcohols such as ethylene glycol, diethylene glycol, propylene glycol, and dipropylene glycol, compounds having an ester bond, such as 2-methoxybutyl acetate, 3-methoxybutyl acetate, 4-methoxybutyl acetate, ethylene glycol monoacetate, diethylene glycol monoacetate, propylene glycol monoacetate, and dipropylene glycol monoacetate, polyhydric alcohol derivatives of compounds having an ether bond such as monoalkyl ether or monophenyl ether, such as monomethyl ether, monoethyl ether, monopropyl ether, or monobutyl ether of polyhydric alcohols or compounds having an ester bond [among these, propylene glycol monomethyl ether acetate (PGMEA) and propylene glycol monomethyl ether (PGME) are preferable], cyclic ethers such as dioxane, esters such as methyl lactate, ethyl lactate (EL), methyl acetate, ethyl acetate, butyl acetate, methyl pyruvate, ethyl pyruvate, methyl methoxypropionate, and ethyl ethoxypropionate, aromatic organic solvents such as anisole, ethylbenzylether, cresylmethylether, diphenylether, dibenzylether, phenetole, butylphenylether, ethylbenzene, diethylbenzene, pentylbenzene, isopropylbenzene, toluene, xylene, cymene, and mesitylene, and dimethylsulfoxide (DMSO).

The component (S) may be used alone or in the form of a mixed solvent obtained by mixing two or more kinds thereof.

In a case where the photosensitive resin composition contains the component (S), the amount thereof used is not particularly limited, and is appropriately set according to the thickness of the coating film at a concentration at which the substrate or the like can be coated with the photosensitive composition without dripping.

For example, the component (S) can be used such that the solid content concentration is 50% by mass or greater, or the component (S) may be used such that the solid content concentration is 60% by mass or greater or 70% by mass or greater.

Further, an aspect in which the photocurable composition does not substantially contain the component (S) (that is, an aspect in which the solid content concentration is 100% by mass) can also be employed.

The photosensitive resin composition of the present embodiment described above contains the hydrogenated bisphenol A type epoxy resin (A1) having an epoxy equivalent of 600 or greater and the photoacid generator (B1) represented by General Formula (b-1).

Since the aromatic ring of the component (A1) is hydrogenated, the rigidity of the component (A1) is lower than that of a bisphenol type epoxy resin or the like used in the related art. Therefore, the Tg and the elastic modulus of the component (A1) are reduced, and the adhesiveness to another substrate is enhanced.

In addition, since the component (A1) has an epoxy equivalent (g/eq) of 600 or greater, the component (A1) is a solid at room temperature. Therefore, the rectangularity of the pattern formed by using the photosensitive resin composition of the present embodiment is enhanced.

Since the component (B1) does not have a fused ring in the cation moiety, the rigidity is reduced. In addition, the component (B1) contains gallium having an anion moiety as a central atom, which has no effect of extending the conjugation. Therefore, the component (B1) has reduced autofluorescence.

It is presumed that the photosensitive resin composition according to the present embodiment can form a pattern having high rectangularity, has satisfactory adhesiveness to another substrate, and can reduce the autofluorescence due to the combined effects described above.

Since the photosensitive resin composition of the present embodiment can form a pattern having high rectangularity, has satisfactory adhesiveness to another substrate, and can reduce the autofluorescence, the photosensitive resin composition can be applied to structures having a function of emitting or receiving light, such as a microchannel device, an image sensor, a microscope, various measuring instruments such as an absorptiometer, and a display.

### (Pattern formation method)

A pattern formation method according to the present embodiment includes a step of forming a photosensitive film on a support using the photosensitive resin composition according to the embodiment described above (hereinafter, referred to as "film formation step"), a step of exposing the photosensitive film to light (hereinafter, referred to as "exposure step"), and a step of developing the photosensitive film exposed to light with a developing solution containing an organic solvent, to form a negative type pattern (hereinafter, referred to as "development step").

For example, the pattern formation method according to the present embodiment can be performed in the following manner.

### [Film formation step]

First, a photosensitive film is formed by coating a support with the photosensitive resin composition according to the embodiment described above using a known method such as a spin coating method, a roll coating method, or a screen printing method and performing a bake (post apply bake (PAB)) treatment under a temperature condition of, for example, 50°C to 150°C for 2 to 60 minutes.

The support is not particularly limited, and a known support of the related art can be used. Examples thereof include a substrate for an electronic component, a substrate on which a predetermined wiring pattern is formed, and a resin suitable for forming a microchannel. More specific examples thereof include silicon, silicon nitride, substrates made of metals such as titanium, tantalum, lithium tantalate (LiTaO₃), niobium, lithium niobate (LiNbO₃), palladium, titanium tungsten, copper, chromium, iron, and aluminum, and glass substrates. As the materials of the wiring pattern, for example, copper, aluminum, nickel, or gold can be used. Examples of the resin include an acrylic resin, polypropylene, a polycarbonate resin, a cycloolefin resin, a polystyrene resin, a polyester resin, a urethane resin, a vinyl chloride resin, a silicone resin, and a fluorine-based resin.

The film thickness of the photosensitive film formed of the photosensitive resin composition is not particularly limited, but is preferably about 10 to 100 µm. Even in a case where a thick film is formed using the photosensitive resin composition according to the embodiment described above, satisfactory characteristics are obtained.

### [Exposure step]

Next, the formed photosensitive film is exposed through a mask having a predetermined pattern (mask pattern) formed thereon using a known exposure device or selectively exposed through drawing or the like by performing direct irradiation with electron beams without using a mask pattern therebetween. In addition, a bake (post exposure bake (PEB)) treatment is performed as necessary under a temperature condition of, for example, 80°C to 150°C for 40 to 1200 seconds, preferably 40 to 1000 seconds and more preferably 60 to 900 seconds.

The wavelength used for the light exposure is not particularly limited, and radiation such as ultraviolet rays having a wavelength of 300 to 500 nm, i-line (wavelength of 365 nm), or visible rays is used for selective irradiation (exposure). A low-pressure mercury lamp, a high-pressure mercury lamp, an ultra-high pressure mercury lamp, a metal halide lamp, an argon gas laser, or the like can be used as a source of the radiation described above.

The radiation here denotes ultraviolet rays, visible rays, far ultraviolet rays, X-rays, electron beams, or the like. The irradiation amount of radiation varies depending on the type and blending amount of each component in the composition, the film thickness of the coating film, and the like, and is 100 to 2000 mJ/cm², for example, in a case of using an ultra-high pressure mercury lamp.

The photosensitive film may be exposed through typical exposure (dry exposure) performed in air or an inert gas such as nitrogen or through liquid immersion exposure (liquid immersion lithography).

The photosensitive film after the exposure step is highly transparent, and the haze value in a case of irradiating the photosensitive film with i-line (wavelength of 365 nm) is preferably 3% or less and more preferably 1.0% to 2.5%.

As described above, the photosensitive film formed of the negative type photosensitive composition according to the embodiment described above is highly transparent. Therefore, the light transmittance is increased during the light exposure in pattern formation so that a negative type pattern with satisfactory lithography characteristics is likely to be obtained.

The haze value of the photosensitive film after the exposure step is measured using a method in conformity with JIS K 7136 (2000).

### [Development step]

Next, the above-described exposed photosensitive film is developed with a developing solution (organic developing solution) containing an organic solvent. After the development, it is preferable that a rinse treatment is performed. A bake treatment (post bake) may be performed as necessary.

The organic solvent contained in the organic developing solution may be obtained by dissolving a component (A) (component (A) before exposure) and can be appropriately selected from known organic solvents. Specific examples thereof include a polar solvent such as a ketone-based solvent, an ester-based solvent, an alcohol-based solvent, a nitrile-based solvent, an amide-based solvent, or an ether-based solvent, and a hydrocarbon-based solvent.

Examples of the ketone-based solvent include 1-octanone, 2-octanone, 1-nonanone, 2-nonanone, acetone, 4-heptanone, 1-hexanone, 2-hexanone, diisobutyl ketone, cyclohexanone, methylcyclohexanone, phenylacetone, methyl ethyl ketone, methyl isobutyl ketone, acetylacetone, acetonylacetone, ionone, diacetonylalcohol, acetylcarbinol, acetophenone, methyl naphthyl ketone, isophorone, propylenecarbonate, γ-butyrolactone, and methyl amyl ketone (2-heptanone). Among these examples, methyl amyl ketone (2-heptanone) is preferable as the ketone-based solvent.

Examples of the ester-based solvent include methyl acetate, butyl acetate, ethyl acetate, isopropyl acetate, amyl acetate, isoamyl acetate, ethyl methoxyacetate, ethyl ethoxyacetate, propylene glycol monomethyl ether acetate (PGMEA), ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Among these, butyl acetate or PGMEA is preferable as the ester-based solvent.

Examples of the nitrile-based solvent include acetonitrile, propionitrile, valeronitrile, and butyronitrile.

Known additives can be blended into the organic developing solution as necessary. Examples of the additive include a surfactant. The surfactant is not particularly limited, and for example, an ionic or non-ionic fluorine-based and/or silicon-based surfactant can be used.

As the surfactant, a non-ionic surfactant is preferable, and a non-ionic fluorine-based surfactant or a non-ionic silicon-based surfactant is more preferable.

In a case where a surfactant is blended into the solution, the amount of the surfactant to be blended is typically 0.001% to 5% by mass, preferably 0.005% to 2% by mass, and more preferably 0.01% to 0.5% by mass with respect to the total amount of the organic developing solution.

The developing treatment can be performed by a known developing method, and examples thereof include a method of immersing a support in a developing solution for a certain time (dip method), a method of raising a developing solution on the surface of a support using the surface tension and maintaining the state for a certain time (puddle method), a method of spraying a developing solution to the surface of a support (spray method), and a method of continuously ejecting a developing solution onto a support rotating at a certain rate while scanning a developing solution ejection nozzle at a certain rate (dynamic dispense method).

The rinse treatment carried out using a rinse solution (washing treatment) can be performed according to a known rinse method. Examples of the method of performing the rinse treatment include a method of continuously ejecting a rinse solution onto a support rotating at a certain rate (rotary coating method), a method of immersing a support in a rinse solution for a certain time (dip method), and a method of spraying a rinse solution to the surface of a support (spray method).

It is preferable that the rinse treatment is performed with a rinse solution containing an organic solvent.

A negative type pattern can be formed by performing the film formation step, the exposure step, and the development step described above.

In the pattern formation method of the above-described embodiment, since the photosensitive resin composition which is the above-described first aspect is used, a pattern having satisfactory adhesiveness to a support and a satisfactory shape with high rectangularity can be formed.

### (Laminate)

The laminate according to the present embodiment includes a support and a cured product of the above-described photosensitive resin composition according to the above-described embodiment, which is subjected to thermocompression bonding onto the support.

The cured product of the photosensitive resin composition is typically obtained by obtaining a support having a pattern using the above-described pattern formation method of the embodiment and performing a curing treatment on the photosensitive resin film.

### (Method for producing laminate)

A method for producing a laminate according to the present embodiment includes a step of obtaining a support having a pattern using the above-described pattern formation method and a step of obtaining a laminate by bonding the support having a pattern to another support by thermocompression bonding.

It is preferable that the photosensitive resin film is cured after the step of obtaining the support having a pattern using the above-described pattern formation method according to the embodiment.

The curing treatment can be performed, for example, under conditions of a temperature of 100°C to 250°C for 0.5 to 2 hours in a nitrogen atmosphere.

According to the method for producing a laminate of the above-described embodiment, a laminate in which the autofluorescence is reduced can be obtained. Therefore, the laminate obtained by the method for producing a laminate according to the above-described embodiment can be applied to structures having a function of emitting or receiving light, such as a microchannel device, an image sensor, a microscope, various measuring instruments such as an absorptiometer, and a display.

### [Examples]

Hereinafter, the present invention will be described in more detail based on examples, but the present invention is not limited to these examples.

### (Examples 1 to 5 and Comparative Examples 1 to 5: Preparation of photosensitive resin composition)

A photosensitive resin composition (solution having a solid content concentration of 65% by mass) of each example was prepared by mixing and dissolving each of the components listed in Tables 1 and 2 in 3-methoxybutyl acetate and filtering the solution through a PTFE filter (manufactured by Pall Corporation, pore diameter: 1 µm).

**[Table 1]**

| | | Example 1 | Example 2 | Example 3 | Example 4 | Example 5 |
|---|---|---|---|---|---|---|
| Resin component | (A1)-1 | 100 | 90 | 60 | 90 | 90 |
| | (A2)-1 | - | - | - | - | |
| | (A2)-3 | - | - | - | 10 | |
| | (A2)-4 | - | 10 | 40 | - | |
| | (A2)-5 | - | - | - | - | |
| | (A2)-6 | - | - | - | - | |
| | (A2)-7 | - | - | - | - | 10 |
| Photoacid generator | (B)-1 | 0.5 | 0.5 | 0.5 | 0.5 | 0.5 |
| | (B)-2 | - | - | - | - | - |
| Evaluation | Adhesiveness | A | A | A | A | A |
| | Autofluorescence | A | A | A | A | A |
| | Pattern rectangularity | A | A | B | A | B |

**[Table 2]**

| | | Comparative Example 1 | Comparative Example 2 | Comparative Example 3 | Comparative Example 4 | Comparative Example 5 |
|---|---|---|---|---|---|---|
| Resin component | (Al)-l | - | - | 100 | - | - |
| | (A2)-1 | - | - | - | 100 | - |
| | (A2)-3 | - | - | - | - | - |
| | (A2)-4 | 100 | - | - | - | 50 |
| | (A2)-5 | - | 100 | - | - | - |
| | (A2)-6 | - | - | - | - | 50 |
| | (A2)-7 | - | - | - | - | - |
| Photoacid generator | (B)-1 | 0.5 | 0.5 | - | 0.5 | 0.5 |
| | (B)-2 | - | - | 0.5 | - | - |
| Evaluation | Adhesiveness | B | C | B | B | C |
| | Autofluorescence | A | B | C | A | A |
| | Pattern rectangularity | B | A | A | C | A |

| | | | | | | |
|---|---|---|---|---|---|---|
| (A1)-1: epoxy resin represented by Chemical Formula (A1-1) (epoxy equivalent: 1000) (A2)-1: epoxy resin represented by Chemical Formula (A2-1) (epoxy equivalent: 200) (A2)-3: epoxy resin represented by Chemical Formula (A2-3) (epoxy equivalent: 1000) (A2)-4: epoxy resin represented by Chemical Formula (A2-4) (epoxy equivalent: 500) (A2)-5: epoxy resin represented by Chemical Formula (A2-5) (epoxy equivalent: 200) (A2)-6: epoxy resin represented by Chemical Formula (A2-6) (epoxy equivalent: 200) (A2)-7: epoxy resin represented by Chemical Formula (A2-7) (epoxy equivalent: 200) | | | | | | |

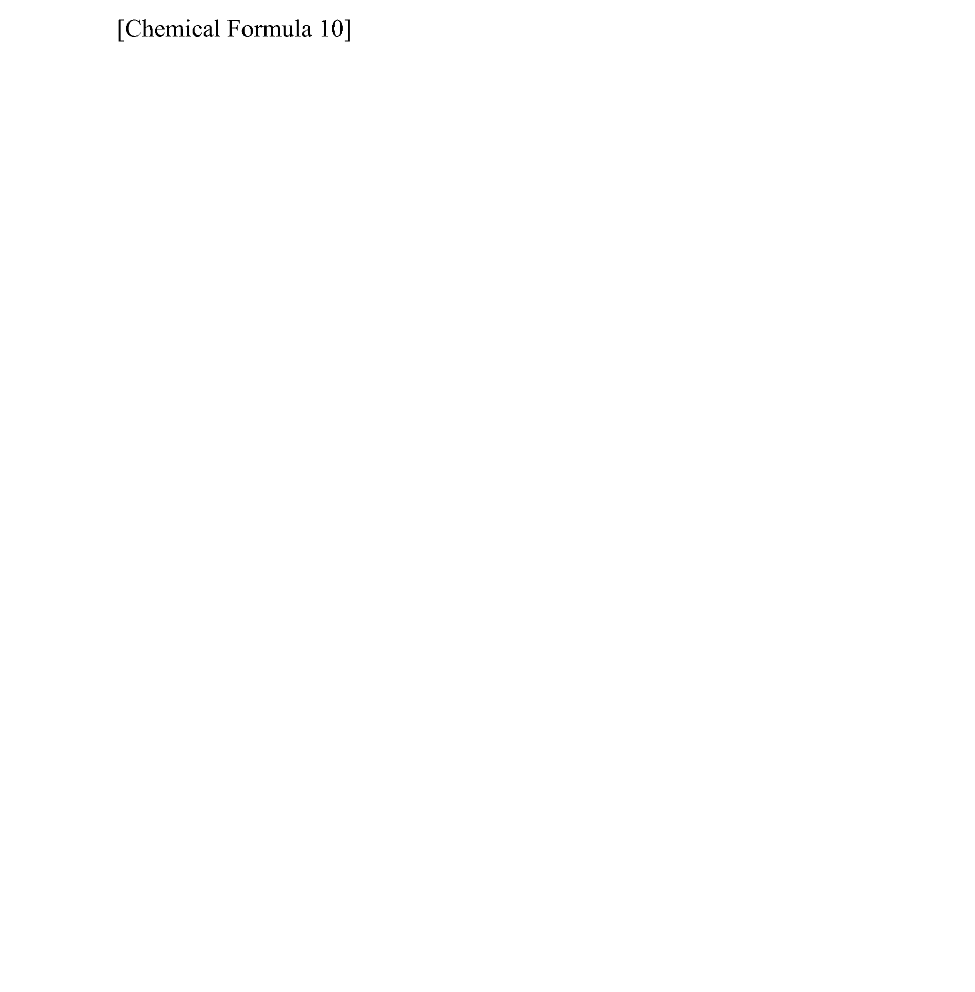

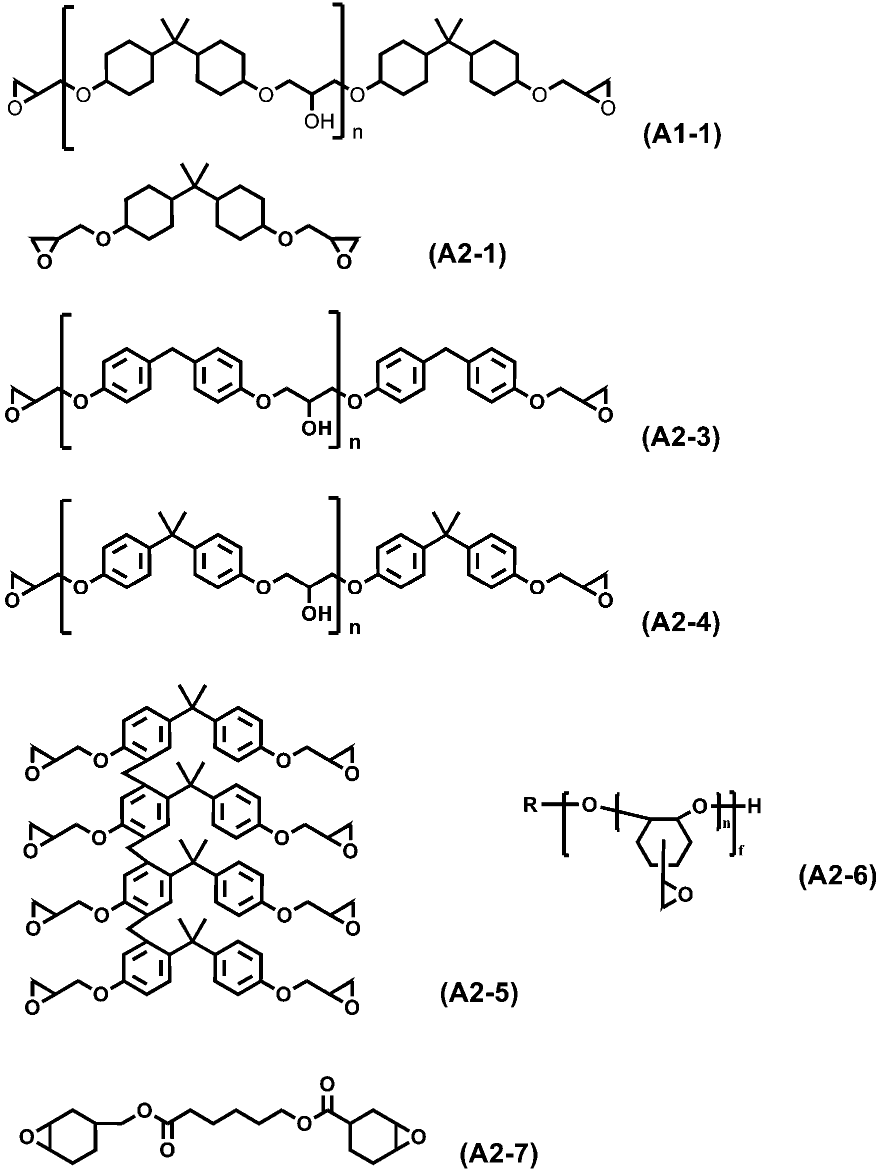

(B)-1: photoacid generator represented by Chemical Formula (B-1)
(B)-2: photoacid generator represented by Chemical Formula (B-2)

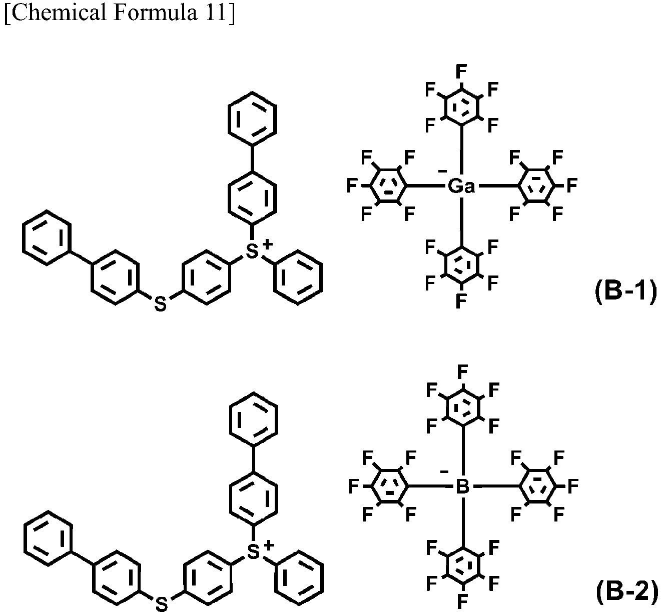

### <Pattern formation>

A silicon (Si) substrate was coated with the photosensitive compositions of each example using a spinner, subjected to a pre-bake (PAB) treatment on a hot plate at a temperature of 100°C for 10 minutes, and dried, thereby forming a photosensitive film having a film thickness of 20 µm.

Next, the photosensitive film was exposed to a ghi-line broadband using a SUSS MA8 aligner.

Thereafter, the photosensitive film was heated on a hot plate at 90°C after exposure for 5 minutes.

Next, development was performed using propylene glycol monomethyl ether acetate (PGMEA) for 120 seconds to form a 1:1 LS pattern.

The negative type pattern was further cured by a heat treatment in an oven (200°C for 1 hour in a nitrogen atmosphere) to form a substrate having a recess in a surface, which was formed of a cured body of the photosensitive resin film.

### <Production of laminate>

A glass chip having a size of 4 mm × 4 mm was thermocompression-bonded to the substrate obtained in the section of "negative type pattern formation" under the conditions of 200°C and 3500 gf for 60 seconds, thereby obtaining a laminate.

### (Evaluation of adhesiveness)

With the laminate obtained in the section of "production of laminate", the adhesiveness of the substrate formed of the cured body of the photosensitive resin film to a 4 mm × 4 mm glass chip was evaluated according to the following criteria. The results are listed in Tables 1 and 2.
A: Adhesion of the substrate formed of the cured body of the photosensitive resin film to 90% or greater of the area of the surface of the glass chip was observed.
B: Adhesion of the substrate formed of the cured body of the photosensitive resin film to 50% to less than 90% of the area of the surface of the glass chip was observed.
C: Adhesion of the substrate formed of the cured body of the photosensitive resin film to less than 50% of the area of the surface of the glass chip was observed.

### (Evaluation of autofluorescence)

The pattern obtained in the section of "pattern formation" was observed with a fluorescence microscope, and the autofluorescence was evaluated by the color intensity of the obtained image. The results are listed in Tables 1 and 2.
A: The intensity was 20 or less.
B: The intensity was greater than 20 and up to 50.
C: The intensity was greater than 50.

### (Evaluation of pattern rectangularity)

The pattern formed in the section of "pattern formation" was observed with a SEM, and the rectangularity was evaluated according to the following criteria. The results thereof are listed in Table 1.
A: The rectangularity was extremely high.
B: The rectangularity was high.
C: The rectangularity was low.

As shown in the results listed in Tables 1 and 2, it was confirmed that the photosensitive resin compositions of the examples can form a pattern having high rectangularity, have satisfactory adhesiveness to another substrate, and can reduce the autofluorescence.

Although the preferable examples of the present invention have been described above, the present invention is not limited to these examples. Additions, omissions, substitutions, and other modifications can be made without departing from the scope of the present invention. Accordingly, the present invention is not limited by the description above but by the scope of the appended claims.

## Claims

1. A photosensitive resin composition comprising:
a hydrogenated bisphenol A type epoxy resin (A1) having an epoxy equivalent of 600 or greater; and
a photoacid generator (B1) represented by General Formula (b-1), 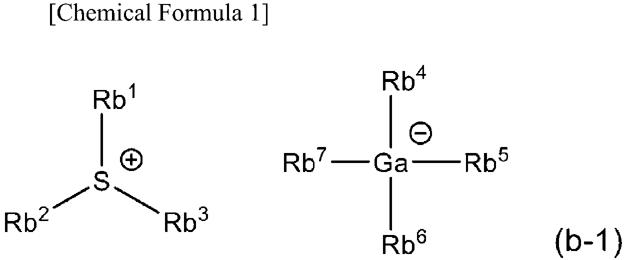
[in the formula, R^{b1} to R^{b3} each independently represent an aryl group, a heteroaryl group, an alkyl group, or an alkenyl group, which may have a substituent, where R^{b1} to R^{b3} have no fused ring, and R^{b4} to R^{b7} each independently represent an aryl group which may have a substituent, or a fluorine atom].

2. The photosensitive resin composition according to Claim 1,
wherein the hydrogenated bisphenol A type epoxy resin (A1) contains a resin (Aep-1) represented by General Formula (Aep-1), 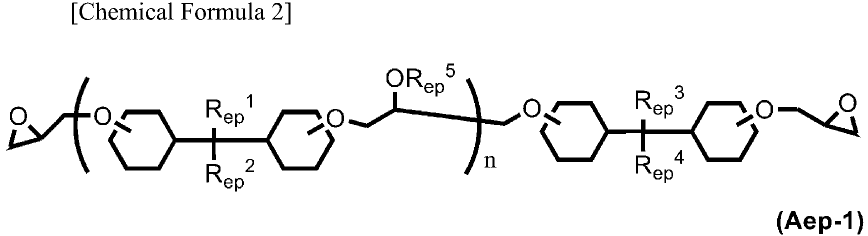
[in the formula, Rep¹ to Rep⁴ each independently represent a hydrogen atom, an alkyl group having 1 to 4 carbon atoms, or a trifluoromethyl group, Rep⁵ represents a hydrogen atom or a glycidyl group, and in a case where a plurality of Rep⁵'s are present, Rep⁵'s may be the same as or different from each other, and n represents an integer of 0 or greater].

3. A pattern formation method comprising:
a step of forming a photosensitive resin film on a support using the photosensitive resin composition according to Claim 1 or 2;
a step of exposing the photosensitive resin film to light; and
a step of developing the photosensitive resin film exposed to light with a developing solution containing an organic solvent, to form a negative type pattern.

4. A method for producing a laminate, comprising:
a step of obtaining a support having a pattern by the pattern formation method according to Claim 3; and
a step of bonding the support having the pattern to another support by thermocompression bonding to obtain a laminate.
